# EUROPEAN PATENT SPECIFICATION

(11) **EP 3 852 200 B1**
(45) Date of publication and mention of the grant of the patent: **29.11.2023**
(21) Application number: 20305022.4
(22) Date of filing: 14.01.2020
(51) Int. Cl.: H01R 9/26, H01R 13/516, H01R 13/518, H01R 13/627, H01H 45/06, H01H 50/06

(54) **SAFETY ELECTRICAL ASSEMBLY WITH A PROTECTIVE COVER HAVING A MAIN OPENING**
ELEKTRISCHE SICHERHEITSANORDNUNG MIT EINER SCHUTZABDECKUNG MIT EINER HAUPTÖFFNUNG
ENSEMBLE ÉLECTRIQUE DE SÉCURITÉ DOTÉ D'UN COUVERCLE DE PROTECTION AVEC UNE OUVERTURE PRINCIPALE

(43) Date of publication of application: 21.07.2021
(73) Proprietor: Tyco Electronics France SAS, 95300 Pontoise (FR)
(72) Inventor: VILLARDIER, Yannick, 69780 MIONS (FR); VILLARD, Romain, 69800 SAINT PRIEST (FR)
(74) Representative: Germain Maureau

(56) References cited:
- EP-A1- 0 940 883
- EP-A2- 0 872 915
- EP-A2- 1 020 959
- DE-A1- 2 849 077
- DE-U1-202010 014 149
- GB-A- 2 292 642

## Description

### Field of the invention

The present invention concerns a safety electrical assembly with a protective cover having a main opening.

### Prior art

It is known to have a safety electrical assembly comprising an electrical apparatus and a protective cover to prevent access to terminals located on the electrical apparatus.

For example, such an electrical apparatus can comprise a row of the terminal blocks cooperating. A protective cover can be mounted on this row of terminal blocks to manage the cables connected to corresponding terminals of the terminal blocks.

In this case, it is known to have several dedicated pre-cut portions of the protective cover that can become individual openings for corresponding cables. Several dimensions of precut portions can exist to enable the passage of different sized cables. This provision enables a protection of the user, as the terminals are not accessible by hand of with a tool such as a screwdriver.

However, the cable management could become an issue as it necessitates a long time for removing the pre-cut portions where necessary. The installation of each cable in the corresponding opening can therefore be difficult. In addition, the protective cover should comprise the precise amount of pre-cut openings corresponding to the electrical apparatus, which means that several protective cover models should be forecasted if different number or size of cables are needed.

The present invention aims to solve all or some of the disadvantages mentioned above.

Document EP0872915 discloses a safety electrical assembly comprising an electrical apparatus having a connecting zone provided with terminals configured to be respectively connected to corresponding cables, each terminal presenting a corresponding connecting opening formed within an insulating housing of the electrical apparatus, a protective cover configured for cooperating with the electrical apparatus in a mounted position wherein the safety electrical assembly presents a main opening configured for the passage of cables connected to corresponding terminals from an exterior area to an interior area of the safety electrical assembly.

### Summary of the invention

For this purpose, the present invention relates to a safety electrical assembly (1) according to claim 1.

In other words, a direct trajectory is a straight line. An obstacle is a physical element from the safety electrical assembly that is intersected by said straight line. Any point of the main opening is to be considered as any point comprised within an area defined by a contour of the main opening. Any point of a connecting opening is to be considered as any point comprised within an area defined by a contour of said connecting opening.

This provision enables to have an effective cover that prevents access to the connecting openings of the terminals, the cover being defined by a simple design as one opening, the main opening, allows the passage of cables connected to corresponding terminals. Requirements of norm IP4x are in addition fulfilled.

The main opening that enables the passage of several cables does not limit the diameter of the cables as the main opening is configured for a certain amount of cables depending on its section. This is to compare with a cover that have several individual openings, each dedicated to a cables size.

According to an aspect of the invention, the main opening is the only opening between the interior area and the exterior area configured for the passage of at least one cable to be connected to at least a corresponding terminal of the connecting zone.

This provision enables a simple cable management as it becomes possible to mount several cables on the connecting zone and then set the cover in mounted position by manually maintaining said cables together. The size of each cable is also not limited by a restrained passage.

According to an aspect of the invention, the main opening is oriented parallel to or obliquely to each connecting opening, an insertion direction in the terminals being opposed to an inlet direction defined by an inlet channel formed from the main opening and oriented towards the interior area.

In other words, the inlet channel corresponds to a channel formed by the safety electrical assembly, in particular by the insulating housing and the protective cover, and starting from the main opening. The inlet direction corresponds to a general flow direction aligned with the walls of the safety electrical assembly constituting the inlet channel.

This enables to have a main opening that can be bigger, and in particular have a bigger order of magnitude, than each connecting openings. At the same time, the connecting openings are protected.

According to an aspect of the invention, the safety electrical assembly is configured to extend according to a longitudinal direction, a part of the protective cover contiguous to the main opening extending farther than the insulating housing of the electrical apparatus according to the longitudinal direction.

This geometrical feature defines the position of the main opening that enables the insulating housing to constitute an obstacle in mounted position as mentioned before.

According to an aspect of the invention, the electrical apparatus comprises a row of terminal blocks, each terminal block comprising an upper side, the connecting zone being located on the upper sides of the terminal blocks.

The terminal blocks can be linked to different sized cables as all the cables can pass through the main opening.

According the invention, the protective cover comprises an upper wall located in front of the connecting zone, the connecting openings being oriented transversally to the upper wall.

In other words, the orientation of a connecting opening is to be understood as the insertion direction of the cable in said connecting opening. Thus, all the cables connected to the electrical apparatus have a similar orientation with regard to the upper wall.

According to an aspect of the invention, at least one group of connecting openings present a tilted orientation with regard to another group of connecting openings.

This means that some of the cables are tilted with regard to others when exiting the connecting zone. This particularly applies when the electrical apparatus is a row of terminal blocks.

According to an example the at least one group of connecting openings with the tilted orientation are inclined with an angle comprised between 20° and 50°, preferably between 25° and 35° and in particular with an angle of 30° with regard to the other group.

According to one example the connecting openings of the other group are oriented substantially perpendicularly to the longitudinal direction. Preferably, connecting openings oriented perpendicularly are push-in openings. Tilted connecting openings are screwed typed openings.

According to another example all the connecting openings are substantially perpendicular to the longitudinal direction. In that case, all the connecting openings are push-in openings.

According to the invention, the protective cover comprises transverse walls that are linked to and extending transversally from the upper wall, at least some of the transverse walls are configured to cooperate with the insulating housing in mounted position.

The protective cover presents a simple design, which simplifies its fabrication.

According to the invention, the transverse walls comprise two opposed side walls and a front wall linked to the two side walls, the sides walls and the front wall defining the main opening.

According to an example a linking region between the upper wall and the front wall presents a curved form.

According to an aspect of the invention, the transverse walls comprise a rear wall transverse to and linking the two side walls, the side walls being attached to a first part of a fastening mechanism of the safety electrical assembly, configured for cooperating with the insulating housing and the rear wall being attached to a second part of the fastening mechanism.

According to an example the first part of the fastening mechanism comprises at least one first fastening element and the second part of the fastening mechanism comprises at least one second fastening element, the at least one first fastening element and the at least one second fastening element being oriented toward each other.

This enables a good grip on the insulating housing. According to an aspect of the invention, the second part of the fastening mechanism comprises a release lever configured to displace the first part of the fastening mechanism with regard to the second part of the fastening mechanism to dismount the protective cover.

According to an example when the electrical apparatus is a row of terminal blocks, the second part of the fastening mechanism comprises an indexed form configured to cooperate with several rear portions of aligned terminal blocks. This enables to easily position the protective cover in mounted position.

According to one aspect of the invention, the protective cover is at least partially transparent.

This enables a visual control of the interior area by a user without dismounting the protective cover. According to an aspect of the invention, the protective cover is made in a non-conductive material, and in particular in plastic.

### Brief description of the figures

The invention will be better understood with the aid of the detailed description that is set out below with reference to the appended drawing in which:
- figure 1 is a sectional view of a safety electrical assembly comprising an electrical apparatus and a protective cover;
- figure 2 is a perspective view of the electrical assembly;
- figure 3 is a perspective view of the electrical assembly from underneath in mounted position;
- figure 4 is another perspective view of the electrical assembly from underneath in mounted position;
- figure 5 is a side view of the protective cover;
- figure 6 is a perspective view of the protective cover from underneath.

### Description with reference to the figures

In the following detailed description of the figures defined above, the same elements or the elements that are fulfilling identical functions may retain the same references so as to simplify the understanding of the invention.

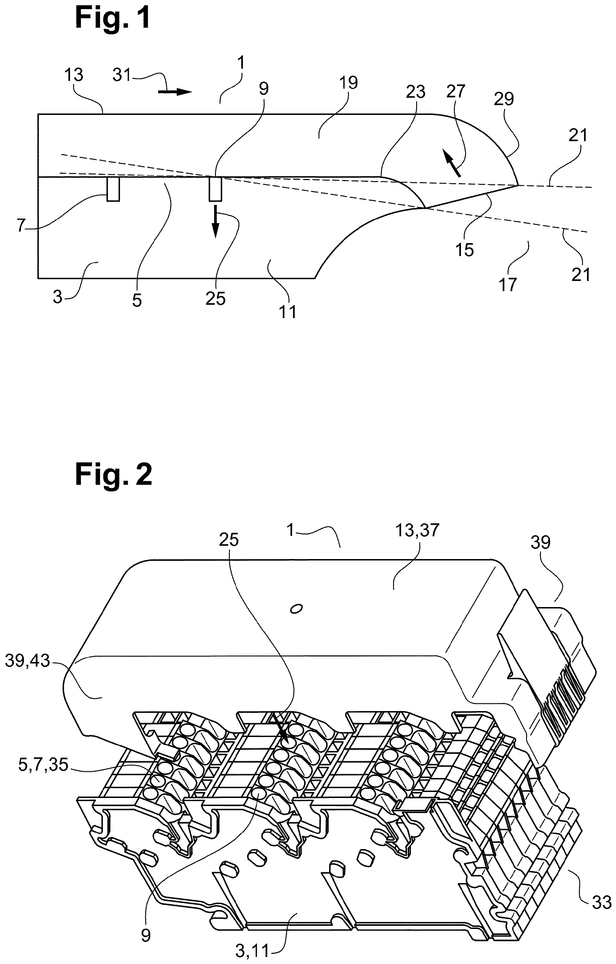

As illustrated in figure 1, a safety electrical assembly 1 comprises an electrical apparatus 3 having a connecting zone 5 provided with terminals 7 configured to be respectively connected to corresponding cables, each terminal 7 presenting a corresponding connecting opening 9 formed within an insulating housing 11 of the electrical apparatus 3.

The safety electrical assembly 1 also comprises a protective cover 13 configured for cooperating with the electrical apparatus 3 in a mounted position. The safety electrical assembly 1 presents a main opening 15 configured for the passage of cables connected to corresponding terminals 7 from an exterior area 17 to an interior area 19 of the safety electrical assembly 1.

The interior area 19 is defined between the electrical apparatus 3 and the protective cover 13. The connecting openings 9 are located in the interior area 19 and the main opening 15 is arranged so that a direct trajectory 21 from any point of the main opening 15 oriented toward any point of any connecting opening 9 intersects an obstacle 23 of the safety electrical assembly 1.

In other words, a direct trajectory 21 is a straight line. An obstacle 23 is a physical element from the safety electrical assembly 1 that is intersected by said straight line. Any point of the main opening 15 is to be considered as any point comprised within an area defined by a contour of the main opening 15. Any point of a connecting opening 9 is to be considered as any point comprised within an area defined by a contour of said connecting opening 9.

The main opening 15 is the only opening between the interior area 19 and the exterior area 17 configured for the passage of at least one cable to be connected to at least a corresponding terminal 7 of the connecting zone 5.

The main opening 15 is oriented parallel to or obliquely to each connecting opening 9, an insertion direction 25 in the terminals being opposed to an inlet direction 27 defined by an inlet channel 29 formed from the main opening 15 and oriented towards the interior area 19.

In other words, the inlet channel 29 corresponds to a channel formed by the safety electrical assembly 1, in particular by the insulating housing 11 and the protective cover 13, and starting from the main opening 15. The inlet direction 27 corresponds to a general flow direction aligned with the walls of the safety electrical assembly 1 constituting the inlet channel 29.

The safety electrical assembly 1 is configured to extend according to a longitudinal direction 31, a part of the protective cover 13 contiguous to the main opening 15 extending farther than the insulating housing 11 of the electrical apparatus 3 according to the longitudinal direction 31.

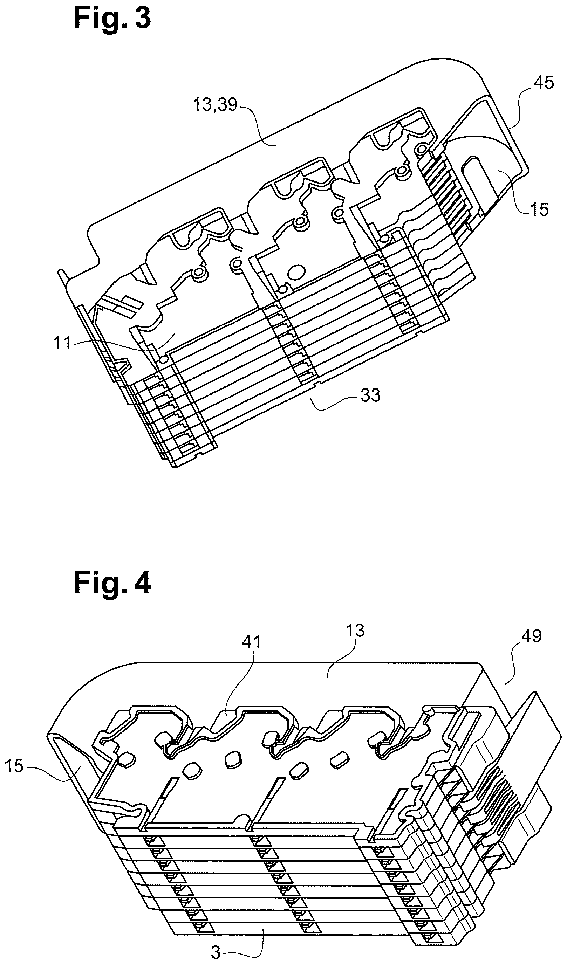

As illustrated in figures 2 to 4, the electrical apparatus 3 comprises a row of terminal blocks 33, each terminal block 33 comprising an upper side 35, the connecting zone 5 being located on the upper sides 35 of the terminal blocks 33.

The protective cover 13 comprises an upper wall 37 located in front of the connecting zone 5, the connecting openings 9 being oriented transversally to the upper wall 37.

In other words, the orientation of a connecting opening 9 is to be understood as the insertion direction 25 of the cable in said connecting opening 9. Thus, all the cables connected to the electrical apparatus 3 have a similar orientation with regard to the upper wall 37.

At least one group of connecting openings 9 present a tilted orientation with regard to another group of connecting openings 9. This means that some of the cables are tilted with regard to others when exiting the connecting zone 5. This particularly applies when the electrical apparatus 3 is a row of terminal blocks 33.

The protective cover 13 comprises transverse walls 39 that are linked to and extending transversally from the upper wall 37, at least some of the transverse walls 37 are configured to cooperate with the insulating housing 11 in mounted position.

The transverse walls 39 are arranged in mounted position to define the main opening 9.

The transverse walls 39 comprise two opposed side walls 43 and a front wall 45 linked to the two side walls, the sides walls 43 and the front wall 45 defining the main opening 15. A linking region 47 between the upper wall 37 and the front wall 45 presents a curved form.

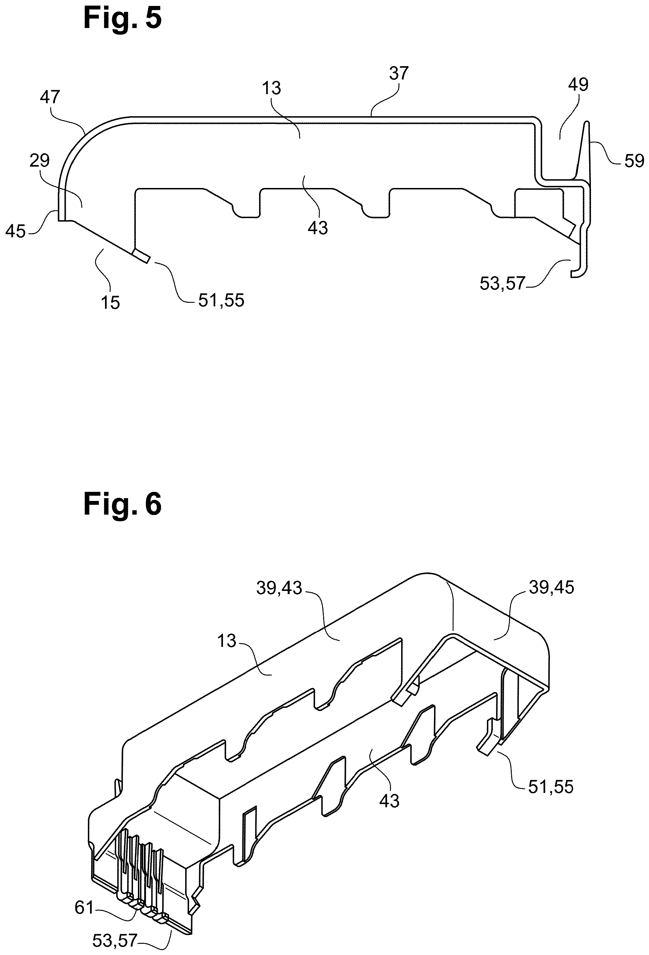

As illustrated in figures 5 and 6, the transverse walls 39 comprise a rear wall 49 transverse to and linking the two side walls 43, the side walls 43 being attached to a first part of a fastening mechanism 51 of the safety electrical assembly 1 configured for cooperating with the insulating housing 11 and the rear wall 49 being attached to a second part of the fastening mechanism 53.

The first part of the fastening mechanism 51 comprises at least one first fastening element 55 and the second part of the fastening mechanism 53 comprises at least one second fastening element 57, the at least one first fastening element 55 and the at least one second fastening element 57 being oriented toward each other.

The second part of the fastening mechanism 55 comprises a release lever 59 configured to displace the first part of the fastening mechanism 51 with regard to the second part of the fastening mechanism 53 to dismount the protective cover 13.

When the electrical apparatus 3 is a row of terminal blocks 33, the second part of the fastening mechanism 53 comprises an indexed form 61 configured to cooperate with several rear portions of aligned terminal blocks 33.

The protective cover 13 is at least partially transparent. The protective cover 13 is made in a non-conductive material, and in particular in plastic.

Overall the safety electrical assembly 1 enables to have an effective cover that prevents access to the connecting openings 9 of the terminals 7, the cover being defined by a simple design as one opening, the main opening, allows the passage of cables connected to corresponding terminals 7. Requirements of norm IP4x are in addition fulfilled.

The main opening 15 that enables the passage of several cables does not limit the diameter of the cables as the main opening is configured for a certain amount of cables depending on its section. This is to compare with a cover that have several individual openings, each dedicated to a cables size.

The cable management becomes simple and enables to mount several cables on the connecting zone 5 and then set the cover in mounted position by manually maintaining said cables together. The size of each cable is also not limited by a restrained passage. Moreover, the simple design simplifies its fabrication.

## Claims

1. Safety electrical assembly (1) comprising :
- an electrical apparatus (3) having a connecting zone (5) provided with terminals (7) configured to be respectively connected to corresponding cables, each terminal (7) presenting a corresponding connecting opening (9) formed within an insulating housing (11) of the electrical apparatus (3),
- a protective cover (13) configured for cooperating with the electrical apparatus (3) in a mounted position wherein the safety electrical assembly (1) presents a main opening (15) configured for the passage of cables connected to corresponding terminals (7) from an exterior area (17) to an interior area (19) of the safety electrical assembly (1), the interior area (19) being defined between the electrical apparatus (3) and the protective cover (13), the connecting openings (9) being located in the interior area (19) and the main opening (15) being arranged so that a direct trajectory (21) from any point of the main opening (15) oriented toward any point of any connecting opening (9) intersects an obstacle (23) of the safety electrical assembly (1), any point of the main opening (15) is to be considered as any point comprised within an area defined by a contour of the main opening (15) and any point of a connecting opening (9) is to be considered as any point comprised within an area defined by a contour of said connecting opening (9), the direct trajectory (21) being a straight line,
wherein the protective cover (13) comprises an upper wall (37) located in front of the connecting zone (5), the connecting openings (9) being oriented transversally to the upper wall (37),
wherein the protective cover (13) comprises transverse walls (39) that are linked to and extending transversally from the upper wall (37), at least some of the transverse walls (39) are configured to cooperate with the insulating housing (11) in mounted position,
wherein the transverse walls (39) comprise two opposed side walls (43) and a front wall (45) linked to the two side walls (43), the sides walls (43) and the front wall (45) defining the main opening (15).

2. Safety electrical assembly (1) according to claim 1, wherein the main opening (15) is the only opening between the interior area (19) and the exterior area (17) configured for the passage of at least one cable to be connected to at least a corresponding terminal (7) of the connecting zone (5).

3. Safety electrical assembly (1) according to one of the claims 1 or 2, wherein the main opening (15) is oriented parallel to or obliquely to each connecting opening (9), an insertion direction (25) in the terminals (7) being opposed to an inlet direction (27) defined by an inlet channel (29) formed from the main opening (15) and oriented towards the interior area (19).

4. Safety electrical assembly (1) according to one of the claims 1 to 3, configured to extend according to a longitudinal direction (31), a part of the protective cover (13) contiguous to the main opening (15) extending farther than the insulating housing (11) of the electrical apparatus (3) according to the longitudinal direction (31).

5. Safety electrical assembly (1) according to one of the claims 1 to 4, wherein the electrical apparatus (3) comprises a row of terminal blocks (33), each terminal block (33) comprising an upper side (35), the connecting zone (5) being located on the upper sides (35) of the terminal blocks (33).

6. Safety electrical assembly (1) according to claim 1 to 5, wherein at least one group of connecting openings (9) present a tilted orientation with regard to another group of connecting openings (9).

7. Safety electrical assembly (1) according to claim 1 to 6, wherein the transverse walls (39) comprise a rear wall (49) transverse to and linking the two side walls (43), the side walls (43) being attached to a first part of a fastening mechanism (51) of the safety electrical assembly (1), configured for cooperating with the insulating housing (11) and the rear wall (49) being attached to a second part of the fastening mechanism (53).

8. Safety electrical assembly (1) according to one of the claims 1 to 7, wherein the protective cover (13) is at least partially transparent.

## Patentansprüche

1. Elektrische Sicherheitsanordnung (1), umfassend:
- eine elektrische Vorrichtung (3), die eine Verbindungszone (5) hat, die mit Anschlüssen (7) versehen ist, die konfiguriert sind, um jeweils mit entsprechenden Kabeln verbunden zu werden, wobei jeder Anschluss (7) eine entsprechende Verbindungsöffnung (9) aufweist, die innerhalb eines Isoliergehäuses (11) der elektrischen Vorrichtung (3) ausgebildet ist,
- eine Schutzabdeckung (13), die konfiguriert ist, um mit der elektrischen Vorrichtung (3) in einer Montageposition zusammenwirken, wobei die elektrische Sicherheitsanordnung (1) eine Hauptöffnung (15) aufweist, die für das Durchführen von Kabeln konfiguriert ist, die mit entsprechenden Anschlüssen (7) verbunden sind, von einem Außenbereich (17) zu einem Innenbereich (19) der elektrischen Sicherheitsanordnung (1), wobei der Innenbereich (19) zwischen der elektrischen Vorrichtung (3) und der Schutzabdeckung (13) definiert ist, wobei sich die Verbindungsöffnungen (9) im Innenbereich (19) befinden und die Hauptöffnung (15) so angeordnet ist, dass eine direkte Trajektorie (21) von jedem beliebigen Punkt der Hauptöffnung (15), die auf jeden beliebigen Punkt jeder beliebigen Verbindungsöffnung (9) ausgerichtet ist, ein Hindernis (23) der elektrischen Sicherheitsanordnung (1) schneidet, wobei ein beliebiger Punkt der Hauptöffnung (15) als beliebiger Punkt zu betrachten ist, der innerhalb eines durch eine Kontur der Hauptöffnung (15) definierten Bereichs liegt, und ein beliebiger Punkt einer Verbindungsöffnung (9) als beliebiger Punkt zu betrachten ist, der innerhalb eines durch eine Kontur der Verbindungsöffnung (9) definierten Bereichs liegt, wobei die direkte Trajektorie (21) eine gerade Linie ist,
wobei die Schutzabdeckung (13) eine obere Wand (37) umfasst, die sich vor der Verbindungszone (5) befindet, wobei die Verbindungsöffnungen (9) quer zur oberen Wand (37) ausgerichtet sind,
wobei die Schutzabdeckung (13) Querwände (39) umfasst, die mit der oberen Wand (37) verbunden sind und sich quer von dieser erstrecken, wobei mindestens einige der Querwände (39) konfiguriert sind, um mit dem Isoliergehäuse (11) in Montageposition zusammenzuwirken,
wobei die Querwände (39) zwei gegenüberliegende Seitenwände (43) und eine Vorderwand (45) umfassen, die mit den zwei Seitenwänden (43) verbunden ist, wobei die Seitenwände (43) und die Vorderwand (45) die Hauptöffnung (15) definieren.

2. Elektrische Sicherheitsanordnung (1) nach Anspruch 1, wobei die Hauptöffnung (15) die einzige Öffnung zwischen dem Innenbereich (19) und dem Außenbereich (17) ist, die für das Durchführen von mindestens einem Kabel konfiguriert ist, das mit mindestens einem entsprechenden Anschluss (7) der Verbindungszone (5) zu verbinden ist.

3. Elektrische Sicherheitsanordnung (1) nach einem der Ansprüche 1 oder 2, wobei die Hauptöffnung (15) parallel oder schräg zu jeder Verbindungsöffnung (9) ausgerichtet ist, wobei eine Einsteckrichtung (25) in den Anschlüssen (7) einer Einführrichtung (27) gegenüberliegt, die durch einen Einführkanal (29) definiert ist, der durch die Hauptöffnung (15) gebildet und auf den Innenbereich (19) ausgerichtet ist.

4. Elektrische Sicherheitsanordnung (1) nach einem der Ansprüche 1 bis 3, die konfiguriert ist, um sich entlang einer Längsrichtung (31) zu erstrecken, wobei sich ein Teil der Schutzabdeckung (13), der mit der Hauptöffnung (15) zusammenhängt, entlang der Längsrichtung (31) weiter erstreckt als das Isoliergehäuse (11) der elektrischen Vorrichtung (3).

5. Elektrische Sicherheitsanordnung (1) nach einem der Ansprüche 1 bis 4, wobei die elektrische Vorrichtung (3) eine Reihe von Klemmenanschlüssen (33) umfasst, wobei jeder Klemmenanschluss (33) eine Oberseite (35) umfasst, wobei sich die Verbindungszone (5) auf den Oberseiten (35) der Klemmenanschlüsse (33) befindet.

6. Elektrische Sicherheitsanordnung (1) nach Anspruch 1 bis 5, wobei mindestens eine Gruppe von Verbindungsöffnungen (9) eine zu einer anderen Gruppe von Verbindungsöffnungen (9) geneigte Ausrichtung aufweist.

7. Elektrische Sicherheitsanordnung (1) nach Anspruch 1 bis 6, wobei die Querwände (39) eine Rückwand (49) umfassen, die quer zu den zwei Seitenwänden (43) verläuft und diese verbindet, wobei die Seitenwände (43) an einem ersten Teil eines Befestigungsmechanismus (51) der elektrischen Sicherheitsanordnung (1) angebracht sind, der konfiguriert ist, um mit dem Isoliergehäuse (11) zusammenwirken, und wobei die Rückwand (49) an einem zweiten Teil des Befestigungsmechanismus (53) angebracht ist.

8. Elektrische Sicherheitsanordnung (1) nach einem der Ansprüche 1 bis 7, wobei die Schutzabdeckung (13) mindestens teilweise transparent ist.

## Revendications

1. Ensemble électrique de sécurité (1) comprenant :
- un appareil électrique (3) ayant une zone de connexion (5) pourvue de bornes (7) configurées pour être respectivement connectées à des câbles correspondants, chaque borne (7) présentant une ouverture de connexion correspondante (9) formée à l'intérieur d'un boîtier isolant (11) de l'appareil électrique (3),
- un couvercle de protection (13) configuré pour coopérer avec l'appareil électrique (3) dans une position montée où l'ensemble électrique de sécurité (1) présente une ouverture principale (15) configurée pour le passage de câbles connectés aux bornes correspondantes (7) d'une zone extérieure (17) à une zone intérieure (19) de l'ensemble électrique de sécurité (1), la zone intérieure (19) étant définie entre l'appareil électrique (3) et le couvercle de protection (13), les ouvertures de connexion (9) étant situées dans la zone intérieure (19) et l'ouverture principale (15) étant agencée de sorte qu'une trajectoire directe (21) depuis tout point de l'ouverture principale (15) orienté vers tout point de toute ouverture de connexion (9) coupe un obstacle (23) de l'ensemble électrique de sécurité (1), tout point de l'ouverture principale (15) doit être considéré comme tout point compris dans une zone définie par un contour de l'ouverture principale (15) et tout point d'une ouverture de connexion (9) doit être considéré comme tout point compris dans une zone définie par un contour de ladite ouverture de connexion (9), la trajectoire directe (21) étant une ligne droite,
dans lequel le couvercle de protection (13) comprend une paroi supérieure (37) située devant la zone de connexion (5), les ouvertures de connexion (9) étant orientées transversalement par rapport à la paroi supérieure (37),
dans lequel le couvercle de protection (13) comprend des parois transversales (39) qui sont reliées à la paroi supérieure (37) et s'étendent transversalement à partir de celle-ci, au moins certaines des parois transversales (39) sont configurées pour coopérer avec le boîtier isolant (11) dans la position montée,
dans lequel les parois transversales (39) comprennent deux parois latérales opposées (43) et une paroi avant (45) reliée aux deux parois latérales (43), les parois latérales (43) et la paroi avant (45) définissant l'ouverture principale (15).

2. Ensemble électrique de sécurité (1) selon la revendication 1, dans lequel l'ouverture principale (15) est la seule ouverture entre la zone intérieure (19) et la zone extérieure (17) configurée pour le passage d'au moins un câble à connecter à au moins une borne correspondante (7) de la zone de connexion (5).

3. Ensemble électrique de sécurité (1) selon l'une des revendications 1 ou 2, dans lequel l'ouverture principale (15) est orientée parallèlement ou obliquement par rapport à chaque ouverture de connexion (9), une direction d'insertion (25) dans les bornes (7) étant opposée à une direction d'entrée (27) définie par un canal d'entrée (29) formé à partir de l'ouverture principale (15) et orientée vers la zone intérieure (19).

4. Ensemble électrique de sécurité (1) selon l'une des revendications 1 à 3, configuré pour s'étendre selon une direction longitudinale (31), une partie du couvercle de protection (13) contigüe à l'ouverture principale (15) s'étendant plus loin que le boîtier isolant (11) de l'appareil électrique (3) selon la direction longitudinale (31).

5. Ensemble électrique de sécurité (1) selon l'une des revendications 1 à 4, dans lequel l'appareil électrique (3) comprend une rangée de borniers (33), chaque bornier (33) comprenant un côté supérieur (35), la zone de connexion (5) étant située sur les côtés supérieurs (35) des borniers (33).

6. Ensemble électrique de sécurité (1) selon les revendications 1 à 5, dans lequel au moins un groupe d'ouvertures de connexion (9) présente une orientation inclinée par rapport à un autre groupe d'ouvertures de connexion (9).

7. Ensemble électrique de sécurité (1) selon les revendications 1 à 6, dans lequel les parois transversales (39) comprennent une paroi arrière (49) transversale aux deux parois latérales (43) et reliant celles-ci, les parois latérales (43) étant fixées à une première partie d'un mécanisme de fixation (51) de l'ensemble électrique de sécurité (1), configurée pour coopérer avec le boîtier isolant (11) et la paroi arrière (49) étant fixée à une deuxième partie du mécanisme de fixation (53).

8. Ensemble électrique de sécurité (1) selon l'une des revendications 1 à 7, dans lequel le couvercle de protection (13) est au moins partiellement transparent.
